# EUROPEAN PATENT APPLICATION

(11) **EP 3 182 402 A2**
(43) Date of publication of application: **21.06.2017**
(21) Application number: 16201315.5
(22) Date of filing: 30.11.2016
(51) Int. Cl.: G09G 3/3266, G09G 3/36, G11C 19/28

(54) **GATE DRIVING CIRCUIT AND DISPLAY DEVICE USING THE SAME**

(30) Priority: 17.12.2015 KR 20150180748
(71) Applicant: LG Display Co., Ltd., Seoul 07336 (KR)
(72) Inventor: LEE, Neunghee, 08826 Seoul (KR); KIM, Byungil, 10087 Gimpo-si, Gyeonggi-do (KR)
(74) Representative: Viering, Jentschura & Partner mbB Patent- und Rechtsanwälte

(57) **Abstract**

Provided are a gate driving circuit and a display device using the same. The gate driving circuit includes: a plurality of stages, each stage sequentially receiving a phase-delayed clock and sequentially generating an output. A kth stage (200) (k is a positive integer) includes: a first inverter (INV1) including a first PMOS transistor (M2) and a first NMOS transistor (M1); a second inverter (INV2) including a second PMOS transistor (M4) and a second NMOS transistor (M3); and a reset signal line (RST_SL) connected to a source terminal of the second NMOS transistor (M3) and supplying a reset signal (RST) to initiate the nth stage (STn).

## Description

### CROSS-REFERENCE TO RELATED APPLICATIONS

This application claims the priority of Korean Patent Application No. 2015-0180748 filed on December 17, 2015, in the Korean Intellectual Property Office.

### BACKGROUND

### Field

The present disclosure relates to a gate driving circuit including a CMOS (complementary metal-oxide-semiconductor) transistor, a display device including the same, and a method of driving a display device including the same.

### Description of the Related Art

With the development of the information society, various demands for display devices for displaying images have been increasing. Accordingly, various flat panel display (FPD) devices with reduced weight and volume compared to cathode ray tubes have recently been developed and commercialized. For example, liquid crystal displays (LCDs), plasma display panels (PDPs) and organic light emitting diode (OLED) display devices are being used.

A display device displays an image using a gate driving circuit supplying scan signals to gate lines on a display panel and a data driving circuit supplying data voltages to data lines. The gate driving circuit may be formed by a Tape Automated Bonding (TAB) method in which a printed circuit board mounted with a plurality of gate drive integrated circuits thereon is bonded to the display panel. Alternatively, the gate driving circuit may be formed by a Gate In Panel (GIP) method in which gate drive integrated circuits are directly formed on the display panel.

As compared with the TAB method, the GIP method is capable of slimming a display device and thus improving visual appearance and also reducing the manufacturing costs thereof. Further, according to the GIP method, a display panel maker can design a plurality of scan signals for compensating a threshold voltage of a driving thin film transistor (TFT) of a pixel. Therefore, in recent years, the gate driving circuit has been formed by the GIP method rather than the TAB method.

According to the GIP method, a shift register in a gate driving circuit includes stages which are connected in a cascade manner and sequentially generate scan signals. The shift register typically needs certain components and signal lines in order to normally drive a GIP driving circuit.

Immediately after the gate driving circuit is powered on, a Q node and a QB node of the shift register are in a random state. In this random state, the gate driving circuit may malfunction and thus generate an abnormal output. For a stable operation of the gate driving circuit, a reset signal is typically supplied to the stages in common in order to perform an initialization of the stages with Q = Low and QB = High. To do so, a switch circuit and a reset (RST) line are further typically needed to supply a reset signal to the gate driving circuit.

Asa result, it may not easy to design a slim bezel area of a display device. In this regard, various researches and developments are recently being conducted to implement a reset signal for stable initiation without increasing the size of a gate driving circuit.

### SUMMARY

Accordingly, the present disclosure is directed to a gate driving circuit including a CMOS (complementary metal-oxide-semiconductor) transistor, a display device including the same, and a method of driving a display device including the same that substantially obviate one or more problems due to limitations and disadvantages of the related art.

An advantage of the present disclosure is to provide a display device with a narrow bezel.

Additional advantages and features of embodiments of the present disclosure will be set forth in part in the description which follows and in part will become apparent to those having ordinary skill in the art upon examination of the following or may be learned from practice of the invention. The objectives and other advantages of embodiments of the present invention may be realized and attained by the structure particularly pointed out in the written description and claims hereof as well as the appended drawings.

A driving circuit of a display device includes: a pixel array where an image is displayed; a data driving circuit supplying data signals to data lines on the pixel array. The driving circuit further includes: a gate driving circuit (or a scan driving circuit) sequentially supplying gate pulses (or scan pulses) synchronized with the data signals to gate lines (or scan lines) on the pixel array. Also, the driving circuit includes: a timing controller controlling the data driving circuit and the gate driving circuit.

Each of pixels may include a thin film transistor (TFT) supplying a voltage of a data line to a pixel electrode in response to a gate pulse supplied through a gate line. The gate pulse swings between a gate high voltage (VGH) and a gate low voltage (VGL). The VGH is set to be higher than a threshold voltage of the TFT formed on the display panel, and the VGL is set to be lower than the threshold voltage of the TFT. The TFTs on the respective pixels are turned on in response to the VGH.

A technology of installing the gate driving circuit together with the pixel array in the display panel has been applied. The gate driving circuit installed in the display panel is known as "Gate In Panel (GIP) circuit". The GIP driving circuit includes a shift register. The shift register includes a plurality of stages connected in a cascade manner.

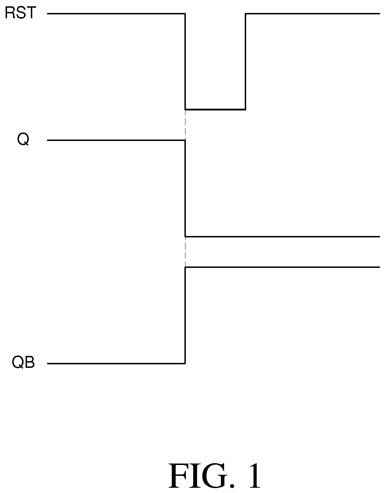

FIG. 1 is a waveform diagram illustrating a reset operation period of a shift register in a gate driving circuit of a conventional display device.

Stages ST1 to STn generate outputs in response to a start pulse and shift the outputs according to a shift clock.

Each of the stages ST1 to STn of the shift register includes a Q node Q for charging a gate line, a Q Bar node QB for discharging the gate line, and a switch circuit connected to the Q node Q and the Q Bar node QB. The switch circuit charges the Q node Q in response to a start pulse or an output of a previous stage to increase a voltage of the gate line. Then, the switch circuit discharges the Q Bar node QB in response to an output of a subsequent stage or a reset signal.

If the shift register is powered on, the Q node Q and the Q Bar node QB are in a random state in which potentials thereof are any one of a high-potential voltage VGH or a low-potential voltage VGL. Therefore, it may be necessary to reset the shift register to a state for an operation of the shift register. That is, the Q node Q is maintained at the low-potential voltage VGL and the Q Bar node QB is set to the high-potential voltage VGH.

Referring to FIG. 1, the reset signal is changed from a high voltage VGH to a low voltage VGL through a reset signal line and then input to a stage of the shift register. As a result, the Q node Q is applied with the low voltage VGL and the Q Bar node QB is applied with the high voltage VGH.

Therefore, if the gate driving circuit is powered on, the Q node Q and the Q Bar node QB are reset to a state for starting an operation of the gate driving circuit.

Generally, a reset signal is supplied to a source terminal of a PMOS transistor to reset a stage of a shift register. The PMOS transistor has a problem with reliability as a reset switch.

Accordingly, the inventors of the present disclosure invented a new structure and method for stable initiation of a shift register without increasing a size of a gate driving circuit.

The present disclosure is provided to solve the above-described problems. According to the present disclosure, an inverted-phase reset signal is supplied to initiate a shift register in a gate driving circuit.

In addition to the above-mentioned objects of the present disclosure, other features and advantages of the present disclosure will be described below, or will be clearly understood by a person having ordinary skill in the art from descriptions below.

According to an aspect of the present disclosure, there is provided a gate driving circuit. The gate driving circuit includes: a plurality of stages which sequentially receive a phase-delayed clock and sequentially generate an output. A kth stage (k is a positive integer) includes: a first inverter including a first PMOS transistor and a first NMOS transistor; a second inverter including a second PMOS transistor and a second NMOS transistor; and a reset signal line connected to a source terminal of the second NMOS transistor and supplying a reset signal to initiate the stage.

In the gate driving circuit according to one or more embodiments of the present disclosure, the reset signal discharges a Q node Q to a low-potential voltage VGL and charges a Q Bar node QB to a high-potential voltage VGH.

In the gate driving circuit according to one or more embodiments of the present disclosure, the reset signal is an inverted phase reset signal which increases from a low-potential voltage VGL to a high-potential voltage VGH and then decreases to the low-potential voltage VGL.

According to exemplary embodiments of the present disclosure, a stage of a gate driving circuit includes: a first inverter including a first PMOS transistor and a first NMOS transistor; a second inverter including a second PMOS transistor and a second NMOS transistor; and a reset signal line connected to a source terminal of the second NMOS transistor and supplying a reset signal to initiate the stage to be operated. As a result, an inverted phase reset signal can be implemented just by changing a signal without adding a transistor. Therefore, it is possible to implement a narrow bezel of a display device without increasing a size of the gate driving circuit.

It is to be understood that both the foregoing general description and the following detailed description of the present invention are exemplary and explanatory and are intended to provide further explanation of the invention as claimed.

### BRIEF DESCRIPTION OF THE DRAWINGS

The above and other aspects, features and other advantages of the present disclosure will be more clearly understood from the following detailed description taken in conjunction with the accompanying drawings, in which:
FIG. 1 is a waveform diagram illustrating a reset operation period of a shift register in a gate driving circuit of a conventional display device;
FIG. 2 is a block diagram illustrating a driving circuit of a display device according to an exemplary embodiment of the present disclosure;
FIG. 3 is a block diagram illustrating a relationship between a plurality of stages of a gate driving circuit and a control signal of the gate driving circuit according to an exemplary embodiment of the present disclosure;
FIG. 4 is a circuit diagram specifically illustrating an nth stage STn illustrated in FIG. 3;
FIG. 5 is a circuit diagram illustrating the nth stage STn illustrated in FIG. 3 as a configuration of switch elements; and
FIG. 6 is a waveform diagram illustrating a reset operation period of the nth stage illustrated in FIG. 4.

### DETAILED DESCRIPTION OF THE ILLUSTRATED EMBODIMENT

Advantages and features of the present disclosure, and methods for accomplishing the same will be more clearly understood from exemplary embodiments described below with reference to the accompanying drawings. However, the present disclosure is not limited to the following exemplary embodiments but may be implemented in various different forms. The exemplary embodiments are provided only to complete disclosure of the present disclosure and to fully provide a person having ordinary skill in the art to which the present disclosure pertains with the category of the disclosure, and the present disclosure will be defined by the appended claims.

The shapes, sizes, ratios, angles, numbers, and the like illustrated in the accompanying drawings for describing the exemplary embodiments of the present disclosure are merely examples, and the present disclosure is not limited thereto. Further, in the following description, a detailed explanation of known related technologies may be omitted to avoid unnecessarily obscuring the subject matter of the present disclosure. The terms such as "including," "having," and "consist of" used herein are generally intended to allow other components to be added unless the terms are used with the term "only". Any references to singular may include plural unless expressly stated otherwise.

Components are interpreted to include an ordinary error range even if not expressly stated.

When the position relation between two parts is described using the terms such as "on", "above", "below", and "next", one or more parts may be positioned between the two parts unless the terms are used with the term "immediately" or "directly".

When an element or layer is referred to as being "on" another element or layer, it may be directly on the other element or layer, or intervening elements or layers may be present.

Although the terms "first", "second", and the like are used for describing various components, these components are not confined by these terms. These terms are merely used for distinguishing one component from the other components. Therefore, a first component to be mentioned below may be a second component in a technical concept of the present disclosure.

Throughout the whole specification, the same reference numerals denote the same elements.

Since size and thickness of each component illustrated in the drawings are represented for convenience in explanation, the present disclosure is not necessarily limited to the illustrated size and thickness of each component.

The features of various embodiments of the present disclosure can be partially or entirely bonded to or combined with each other and can be interlocked and operated in technically various ways as can be fully understood by a person having ordinary skill in the art, and the embodiments can be carried out independently of or in association with each other.

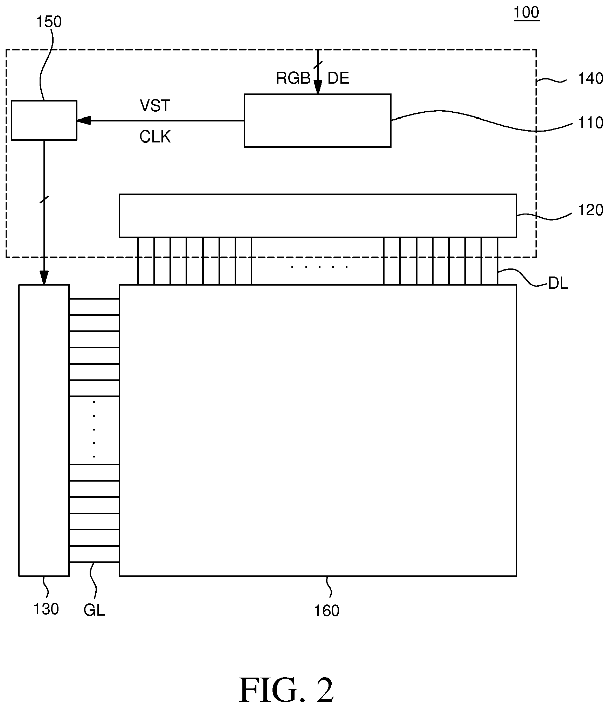

Hereinafter, various exemplary embodiments of the present disclosure will be described in detail with reference to FIG. 2 through FIG. 6.

FIG. 2 is a block diagram illustrating a driving circuit of a display device according to an exemplary embodiment of the present disclosure.

Referring to FIG. 2, a display device according to an exemplary embodiment of the present disclosure includes a display panel 160, a data driving circuit 120, a level shifter 150, a shift register 130, a PCB 140, and a timing controller 110.

The display panel 160 includes data lines DL and gate lines GL intersecting with each other and pixels disposed in a matrix shape. The display panel 160 may be a liquid crystal display (LCD), an organic light emitting diode (OLED), an electrophoretic display (EPD), or the like.

The data driving circuit 120 includes a plurality of source drive ICs. The data driving circuit 120 receives digital video data RGB from the timing controller 110. The data driving circuit 120 converts the digital video data RGB into a gamma correction voltage to generate a data voltage, in response to a source timing control signal from the timing controller 110. Then, the data driving circuit 120 supplies the data voltage to the data lines of the display panel 160 in synchronization with a gate pulse. The data driving circuit 120 may be connected to the data lines DL of the display panel 160 through a Chip On Glass (COG) process or a Tape Automated Bonding (TAB) process.

A gate driving circuit includes the level shifter 150 and the shift register 130 connected between the timing controller 110 and the gate lines GL of the display panel 160.

The level shifter 150 level-shifts a transistor-transistor-logic (TTL) level voltage of a shift clock CLK input from the timing controller 110 to a high voltage VGH and a low voltage VGL. In the following exemplary embodiment of the present disclosure, driving using the shift clock CLK will be exemplified.

The shift register 130 includes stages which shift a start pulse VST according to the shift clock CLK and sequentially output a carry signal and a gate pulse Gout.

The gate driving circuit may be directly formed on a lower substrate of the display panel 160 by a Gate In Panel (GIP) method. According to the GIP method, the level shifter 150 may be mounted on the PCB 140 and the shift register 130 may be formed on the lower substrate of the display panel 160.

The timing controller 110 receives digital video data RGB from an external host computer through an interface such as a Low Voltage Differential Signaling (LVDS) interface, a Transition Minimized Differential Signaling (TMDS) interface, or the like. The timing controller 110 transmits the digital video data RGB input from the host computer to the source drive ICs 120.

The timing controller 110 receives timing signals, such as a vertical synchronization signal Vsync, a horizontal synchronization signal Hsync, a data enable signal DE, and a main clock MCLK from the host computer through an LVDS or TMDS interface receiving circuit. The timing controller 110 generates timing control signals to control an operation timing of the data driving circuit and the gate driving circuit based on the timing signals from the host computer. The timing control signals include a scan timing control signal to control an operation timing of the gate driving circuit and a data timing control signal to control an operation timing of the data driving circuit 120 and the polarity of a data voltage.

A gate timing control signal includes a start pulse VST, a shift clock CLK, and a gate output enable signal GOE. The start pulse VST is input to the shift register 130 and controls a shift start timing.

The shift clock CLK is level-shifted by the level shifter 150 and then input to the shift register 130 and used as a clock signal for shifting the start pulse VST. The gate output enable signal GOE controls an output timing of the gate shift register 130.

The data timing control signal includes a source start pulse SSP, a source sampling clock SSC, a polarity control signal POL, and a source output enable signal SOE, and the like. The source start pulse SSP controls a shift start timing of the source drive ICs 120. The source sampling clock SSC is a clock signal that controls a sampling timing of data within the source driver ICs 120 based on a rising or falling edge thereof.

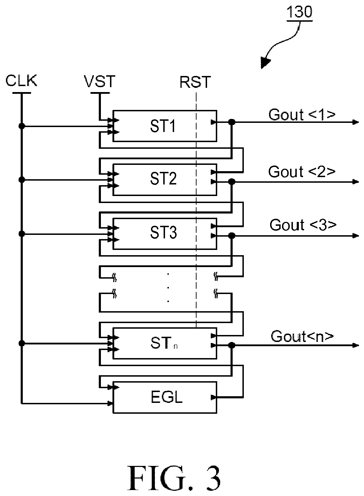

FIG. 3 is a block diagram illustrating a relationship between a plurality of stages of a gate driving circuit and a control signal of the gate driving circuit according to an exemplary embodiment of the present disclosure.

The gate driving circuit may be formed on one edge or both edges of the display panel 160 outside a pixel array. The GIP-type gate driving circuit and the pixel array may be formed on the substrate of the display panel 160 at the same time. The gate driving circuit includes a plurality of stages ST1 to STn to which the start pulse VST and the shift clock CLK are input.

The stages ST1 to STn generate outputs in response to the start pulse VST and shift the outputs according to the shift clock CLK.

A shift register SR according to an exemplary embodiment of the present disclosure is configured as a latch circuit. Each of the stages ST1 to STn of the shift register SR includes a Q node Q for charging a gate line, a Q Bar node QB for discharging the gate line, and a switch circuit connected to the Q node Q and the Q Bar node QB. The switch circuit charges the Q node Q in response to a start pulse or an output of a previous stage to increase a voltage of the gate line. Then, the switch circuit discharges the Q Bar node QB in response to an output of a subsequent stage or a reset signal. The switch circuit includes TFTs of configuration as a metal oxide semiconductor field effect transistor (MOSFET).

If the shift register SR is powered on, potentials of the Q node Q and the Q Bar node QB are randomly set to a high-potential voltage VGH or a low-potential voltage VGL. Therefore, it may be necessary to reset the shift register SR to a state for an operation of the shift register SR. That is, the Q node Q is maintained at the low-potential voltage VGL and the Q Bar node QB is set to the high-potential voltage VGH.

Referring to FIG. 3, the shift register SR according to an exemplary embodiment of the present disclosure includes a plurality of stages ST1 to STn (n is a natural number equal to or greater than 2) connected in a cascade manner. The stages ST1 to STn output first to nth gate pulses Gout1 to Goutn, respectively. While the gate pulses Gout1 to Goutn are applied to the gate lines of the display device, the gate pulses Gout1 to Goutn also serve as first carry signals Gout_pre and second carry signals Gout_post transferred to a previous stage and a subsequent stage. In the following, the term "previous stage" refers to a stage positioned above a reference stage.

For example, on the basis of a kth stage STk (k is a natural number satisfying 1 < k < n), the previous stage refers to any one of a first stage ST1 to a k-1th stage ST (k-1).

Further, the term "subsequent stage" refers to a stage positioned under the reference stage. For example, on the basis of the kth stage STk (1 < k < n), the subsequent stage refers to any one of a k+1th stage ST (k+1) to an nth stage.

Referring to FIG. 3, the shift register according to an exemplary embodiment of the present disclosure subsequently outputs gate pulses Gout(1) to Gout(n). In order to do so, sequentially delayed shift clocks CLK are input to the first stage ST1 to the nth stage STn.

The stages ST1 to STn of the shift register SR start outputting the gate pulses Gout1 to Goutn in response to the start pulse VST and shift the gate pulses Gout1 to Goutn in response to the shift clock CLK. The gate pulses Gout1 to Goutn respectively output from the stages ST1 to STn are supplied to the gate lines while being input to following stages as the first carry signals Gout_Pre. The first carry signals Gout_Pre are used for pre-charging the Q node in order for the stages ST1 to STn to respectively generate outputs. However, the first carry signal Gout_Pre is not input to the first stage ST1, but the gate start pulse VST is input to the first stage ST1.

Further, after generating output signals, the stages ST1 to STn respectively receive the second carry signals Gout_Post for discharging the Q node. However, the second carry signal Gout_Post is not input to the nth stage STn which is the last stage.

Referring to FIG. 3, the gate shift register according to an exemplary embodiment of the present disclosure further includes dummy stages which do not generate outputs but supply the second carry signals Gout_Post to the other stages. For example, an nth stage (n is a positive integer equal to or greater than 2) outputting the last gate pulse is connected to an n+1th stage (or end generator). The n+1th stage does not output a gate pulse but supplies the second carry signal Gout_Post to the nth stage.

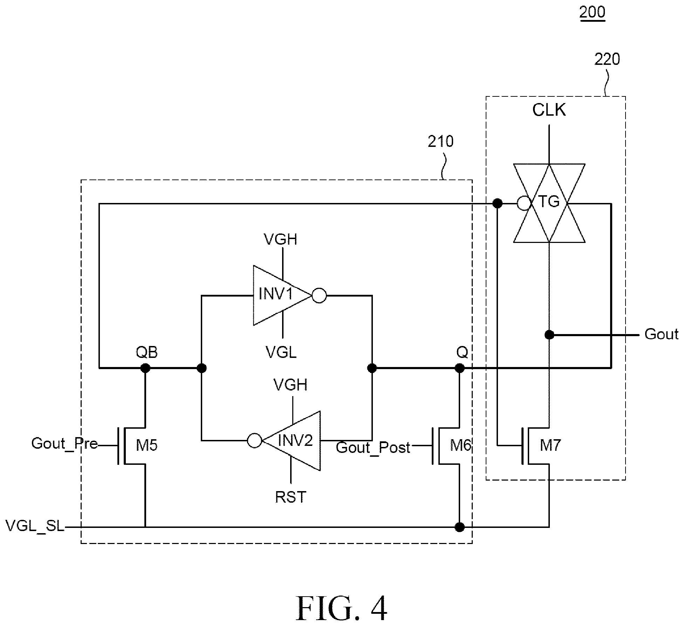

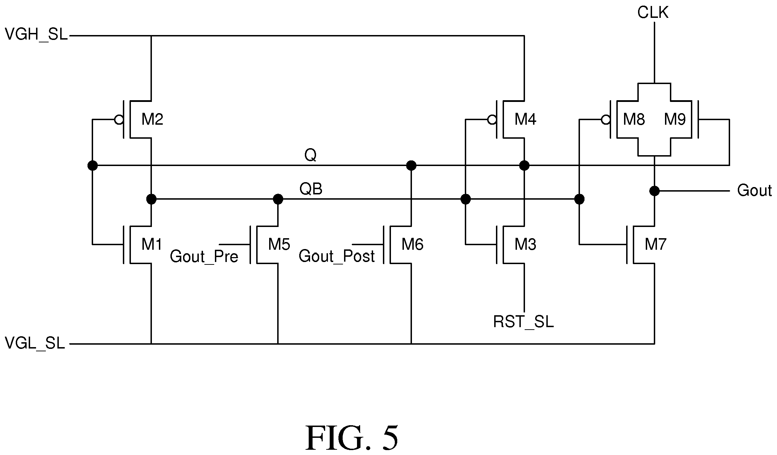

FIG. 4 is a circuit diagram specifically illustrating an nth stage STn illustrated in FIG. 3. FIG. 5 is a circuit diagram illustrating the nth stage STn illustrated in FIG. 3 as a configuration of switch elements.

In FIG. 4 and FIG. 5, M1, M3, M5, M6, M7, and M9 are implemented with an n-type MOSFET (hereinafter, referred to as "NMOS"), and M2, M4, and M8 are implemented with a p-type MOSFET (hereinafter, referred to as "PMOS"). Hereinafter, referring to FIG. 4 and FIG. 5, an nth stage STn of the shift register will be described.

Referring to FIG. 4 and FIG. 5, an nth stage (STn) 200 of the shift register according to an exemplary embodiment of the present disclosure includes a latch 210 and a buffer 220.

A reset signal RST, a shift clock CLK, a carry signal Gout_Pre or start pulse VST received from a previous stage, a gate high voltage VGH, and a gate low voltage VGL are input to each shift register 130. The first carry signal Gout_Pre input to an nth stage except a first stage is an output Gout of an n-1th stage. The first carry signal Gout_Pre is not input to the first stage ST1, but the start pulse VST is input to the first stage ST1.

The latch 210 includes two inverters INV1 and INV2 connected by a closed loop-shaped feedback circuit and adjusts a voltage of the Q Bar node QB in a state in which a voltage of the Q node Q is inverted.

The latch 210 is formed by the two inverters configured as CMOS transistors in a feedback manner. The Q Bar node QB of the latch 210 is connected to a drain terminal of a third NMOS M5 and controlled by the first carry signal Gout_Pre connected to a gate terminal of the third NMOS M5. Further, the Q node Q of the latch 210 is connected to a drain terminal of a fourth NMOS M6 and controlled by the second carry signal Gout_post connected to a gate terminal of the fourth NMOS M6.

A first inverter INV1 includes a first NMOS M1 and a first PMOS M2. A second inverter INV2 includes a second NMOS M3 and a second PMOS M4. The first inverter INV1 supplies an inverted signal of the Q Bar node QB to the Q node Q. The first NMOS M1 includes a gate connected to the Q node Q, a drain connected to the Q Bar node QB, and a source connected to a VGL line VGL_SL. The first PMOS M2 includes a gate connected to the Q node Q, a drain connected to the Q Bar node QB, and a source connected to a VGH line VGH_SL.

The second inverter INV2 supplies an inverted signal of the Q node Q to the Q Bar node QB. The second NMOS M3 includes a gate connected to the Q Bar node QB, a drain connected to the Q node Q, and a source connected to a reset signal line RST_SL. The second PMOS M4 includes a gate connected to the Q Bar node QB, a drain connected to the Q node Q, and a source connected to the VGH line VGH_SL. The buffer 220 includes a pull-up transistor that supplies a shift clock CLK to an output terminal in response to a voltage of the Q node Q, for the rising of an output voltage Gout. Further, the buffer 220 includes a pull-down transistor that discharges the output terminal in response to a voltage of the Q Bar node QB, for the falling of the output voltage Gout.

The pull-up transistor includes a transmission gate TG in which a sixth NMOS M9 and a third PMOS M8 are connected in parallel. The pull-down transistor includes a fifth NMOS M7. The output voltage Gout is a gate pulse supplied to a gate line.

The third PMOS M8 of the transmission gate TG includes a gate connected to the Q Bar node QB, a drain connected to the output terminal, and a source to which the shift clock CLK is input. Further, the sixth NMOS M9 of the transmission gate TG includes a gate connected to the Q node Q, a source connected to the output terminal, and a drain to which the shift clock CLK is input.

The fifth NMOS M7 includes a gate connected to the Q Bar node QB, a drain connected to the output terminal, and a source connected to the VGL line VGL_SL.

If a high-potential voltage VGH is applied to the Q node Q, the buffer 220 increases a gate pulse of the shift clock CLK to the output voltage Gout. Further, if the high-potential voltage VGH is applied to the Q Bar node QB, the buffer 220 decreases a low-potential voltage VGL transmitted from the VGL line VGL_SL to the output voltage Gout through the fifth NMOS M7.

Therefore, in the shift register 130 according to an exemplary embodiment of the present disclosure, the latch includes the two inverters configured in a feedback manner and the Q node Q and the Q Bar node QB are connected to the drains of the NMOS M5 and M6. Thus, the Q node Q and the Q Bar node QB are controlled by the first carry signal Gout_pre and the second carry signal Gout_post. Therefore, the output voltage Gout of the shift register is controlled by a gate pulse of the shift clock CLK.

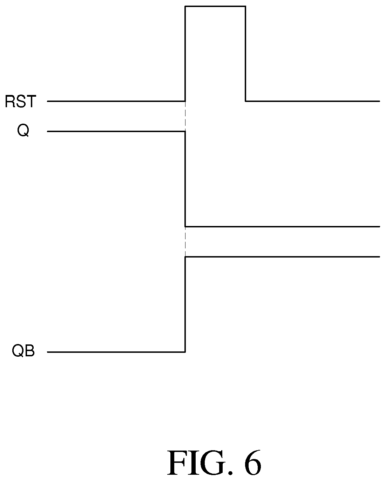

FIG. 6 is a waveform diagram illustrating a reset operation period of the nth stage illustrated in FIG. 4.

Each of the stages ST1 to STn of the shift register includes a Q node Q for charging a gate line, a Q Bar node QB for discharging the gate line, and a switch circuit connected to the Q node Q and the Q Bar node QB. The switch circuit charges the Q node Q in response to a start pulse or an output of a previous stage to increase a voltage of the gate line. Then, the switch circuit discharges the Q Bar node QB in response to an output of a subsequent stage or a reset signal RST.

Referring to FIG. 6, if the shift register according to an exemplary embodiment of the present disclosure is powered on, the Q node Q and the Q Bar node QB connected to the two inverters INV1 and INV2 connected by the closed loop-shaped feedback circuit are in a random state in which potentials thereof are any one of a high-potential voltage VGH or a low-potential voltage VGL. Then, a reset signal RST is input to the second NMOS M3 of the second inverter INV2. That is, the reset signal is converted from a low voltage VGL to a high voltage VGH through the reset signal line RST_SL and then input to the second NMOS M3 of the second inverter INV2. As a result, the Q node Q is maintained at the low-potential voltage VGL and the Q Bar node QB is set to the high-potential voltage VGH.

Therefore, if the gate driving circuit is powered on, the Q node Q and the Q Bar node QB are reset to a state for starting an operation of the gate driving circuit.

When the gate driving circuit according to an exemplary embodiment of the present disclosure starts an operation, the reset signal RST increases from the low-potential voltage VGL to the high-potential voltage VGH and then decreases to the low-potential voltage VGL. Therefore, the reset signal RST has a phase inverted to that of a conventional reset signal. Unlike the conventional reset signal RST which is input to the second PMOS M4 of the first inverter INV1, the inverted phase reset signal RST according to an exemplary embodiment of the present disclosure initiates the shift register of the gate driving circuit using the second NMOS M3 of the second inverter INV2.

As described above, in the gate driving circuit according to an exemplary embodiment of the present disclosure, an inverted phase reset signal RST is input to each stage to initiate the stage. As a result, a reset period of the shift register of the gate driving circuit has a high reliability. Further, any additional switch is not needed to initiate the shift register.

The exemplary embodiments of the present disclosure can also be described as follows:

According to an aspect of the present disclosure, there is provided a gate driving circuit. The gate driving circuit includes: a plurality of stages which sequentially receive a phase-delayed clock and sequentially generate an output. A kth stage (k is a positive integer) includes: a first inverter including a first PMOS transistor and a first NMOS transistor; a second inverter including a second PMOS transistor and a second NMOS transistor; and a reset signal line connected to a source terminal of the second NMOS transistor and supplying a reset signal to initiate the stage.

The reset signal may discharge a Q node Q to a low-potential voltage VGL and may charge a Q Bar node QB to a high-potential voltage VGH.

The reset signal may be an inverted phase reset signal which increases from a low-potential voltage VGL to a high-potential voltage VGH and then decreases to the low-potential voltage VGL.

The first inverter and the second inverter may constitute a latch as being connected by a closed loop-shaped feedback circuit.

The latch may control a voltage to be applied to the Q Bar node QB in a state in which a voltage applied to the Q node Q is inverted.

The first PMOS transistor may include a gate connected to the Q node, a drain connected to the QB node, and a source connected to a high-potential voltage line. The first NMOS transistor may include a gate connected to the Q node, a drain connected to the QB node, and a source connected to a low-potential voltage line. The second PMOS transistor may include a gate connected to the QB node, a drain connected to the Q node, and a source connected to the high-potential voltage line. The second NMOS transistor may include a gate connected to the QB node, a drain connected to the Q node, and a source connected to the reset signal line.

The kth stage may further include: a first switch receiving a carry signal from a k-1th stage and controlling the QB node to a low voltage and the Q node to a high voltage when the carry signal has a high voltage; a second switch receiving a carry signal from a k+1th stage and controlling the QB node to a high voltage and the Q node to a low voltage when the carry signal has a high voltage; and a buffer outputting the clock as an output voltage when a voltage of the Q node is a high voltage and outputting a low voltage as an output voltage when a voltage of the QB node is a high voltage.

The buffer may include: a pull-up transistor supplying the clock to an output terminal in response to the voltage of the Q node to increase the output voltage; and a pull-down transistor supplying the low voltage to the output terminal in response to the voltage of the QB node to decrease the output voltage.

The pull-up transistor may be a transmission gate.

The transmission gate may include: a third PMOS transistor including a gate connected to the QB node, a drain connected to the output terminal, and a source to which the clock is input; and a third NMOS transistor including a gate connected to the Q node, a source connected to the output terminal, and a drain to which the clock is input.

The pull-down transistor may be a fourth NMOS transistor including a gate connected to the QB node, a drain connected to the output terminal, and a source connected to the low-potential voltage line.

The first switch may be a fifth NMOS transistor including a gate connected to a carry signal transmission line from the k-1th stage, a drain connected to the QB node, and a source connected to the low-potential voltage line.

The second switch may be a sixth NMOS transistor including a gate connected to a carry signal transmission line from the k+1th stage, a drain connected to the Q node, and a source connected to the low-potential voltage line.

## Claims

1. A gate driving circuit comprising:
a plurality of stages (ST1, ..., STn) including an kth stage (200), wherein k is a positive integer, each stage configured to sequentially receive a phase-delayed clock (CLK) and sequentially generate an output (Gout<1>, ..., Gout<n>),
wherein the kth stage (200) includes:
a first inverter (INV1) including a first PMOS transistor (M2) and a first NMOS transistor (M1);
a second inverter (INV2) including a second PMOS transistor (M4) and a second NMOS transistor (M3); and
a reset signal line (RST_SL) connected to a source terminal of the second NMOS transistor NM3) and configured to supply a reset signal (RST) to initiate the kth stage (200).

2. The gate driving circuit according to claim 1, wherein the reset signal (RST) discharges a Q node (Q) to a low-potential voltage (VGL) and charges a Q Bar node (QB) to a high-potential voltage (VGH).

3. The gate driving circuit according to claim 1 or 2, wherein the reset signal (RST) is an inverted phase reset signal which increases from a low-potential voltage (VGL) to a high-potential voltage (VGH) and then decreases to the low-potential voltage (VGL).

4. The gate driving circuit according to any one of claims 1 to 3, wherein the first inverter (INV1) and the second inverter (INV2) constitute a latch (210) as being connected by a closed loop-shaped feedback circuit.

5. The gate driving circuit according to claim 4, wherein the latch (210) is configured to control a voltage to be applied to the Q Bar node (QB) in a state in which a voltage applied to the Q node (Q) is inverted.

6. The gate driving circuit according to any one of claims 2 to 5, wherein the first PMOS transistor (M2) includes a gate connected to the Q node (Q), a drain connected to the Q Bar node (QB), and a source connected to a high-potential voltage line (VGH_SL),
the first NMOS transistor (M1) includes a gate connected to the Q node (Q), a drain connected to the Q Bar node (QB), and a source connected to a low-potential voltage line (VGL_SL),
the second PMOS transistor (M4) includes a gate connected to the Q Bar node (QB), a drain connected to the Q node (Q), and a source connected to the high-potential voltage line (VGH_SL), and
the second NMOS transistor (M3) includes a gate connected to the Q Bar node (QB), a drain connected to the Q node (Q), and a source connected to the reset signal line (RST_SL).

7. The gate driving circuit according to any one of claims 2 to 6, wherein the kth stage (200) further includes:
a first switch configured to receive a carry signal (Gout_Pre) from a k-1th stage and control the Q Bar node (QB) to a low voltage and the Q node (Q) to a high voltage when the carry signal (Gout_Pre) has a high voltage;
a second switch configured to receive a carry signal (Gout_Post) from a k+1th stage and control the Q Bar node (QB) to a high voltage and the Q node (Q) to a low voltage when the carry signal (Gout_Post) has a high voltage; and
a buffer (220) configured to output the clock as an output voltage (Gout) when a voltage of the Q node (Q) is a high voltage and output a low voltage as an output voltage (Gout) when a voltage of the Q Bar node (QB) is a high voltage.

8. The gate driving circuit according to claim 7, wherein the buffer (220) includes:
a pull-up transistor configured to supply the clock (CLK) to an output terminal in response to the voltage of the Q node (Q) to increase the output voltage (Gout); and
a pull-down transistor configured to supply the low voltage to the output terminal in response to the voltage of the Q Bar node (QB) to decrease the output voltage (Gout).

9. The gate driving circuit according to claim 8, wherein the pull-up transistor is a transmission gate (TG).

10. The gate driving circuit according to claim 9, wherein the transmission gate (TG) includes:
a third PMOS transistor (M8) including a gate connected to the Q Bar node (QB), a drain connected to the output terminal, and a source to which the clock (CLK) is input; and
a third NMOS transistor (M9) including a gate connected to the Q node (Q), a source connected to the output terminal, and a drain to which the clock (CLK) is input.

11. The gate driving circuit according to any one of claims 8 to 10, wherein the pull-down transistor is a fourth NMOS transistor (M7) including a gate connected to the Q Bar node (QB), a drain connected to the output terminal, and a source connected to the low-potential voltage line (VGL_SL).

12. The gate driving circuit according to any one of claims 7 to 11, wherein the first switch is a fifth NMOS transistor (M5) including a gate connected to a carry signal transmission line from the k-1th stage, a drain connected to the Q Bar node (QB), and a source connected to the low-potential voltage line (VGL_SL).

13. The gate driving circuit according to any one of claims 7 to 12, wherein the second switch is a sixth NMOS transistor (M6) including a gate connected to a carry signal transmission line from the k+1th stage, a drain connected to the Q node (Q), and a source connected to the low-potential voltage line (VGL_SL).

14. A display device including the gate driving circuit according to any one of claims 1 to 13.

15. The display device according to claim 14, wherein the gate driving circuit is a Gate-In-Panel circuit on a substrate of the display device.
